# EUROPÄISCHE PATENTSCHRIFT

(11) **EP 2 668 676 B1**
(45) Veröffentlichungstag und Bekanntmachung des Hinweises auf die Patenterteilung: **19.12.2018**
(21) Anmeldenummer: 12701732.5
(22) Anmeldetag: 25.01.2012
(51) Int. Cl.: H01L 35/00

(54) **THERMOELEKTRISCHES MODUL MIT EINER WÄRMELEITSCHICHT**
THERMOELECTRIC MODULE COMPRISING A HEAT CONDUCTING LAYER
MODULE THERMOÉLECTRIQUE MUNI D'UNE COUCHE THERMOCONDUCTRICE

(30) Priorität: 26.01.2011 DE 102011009428
(43) Veröffentlichungstag der Anmeldung: 04.12.2013
(73) Patentinhaber: Continental Automotive GmbH, 30165 Hannover (DE); Bayerische Motoren Werke Aktiengesellschaft, 80809 München (DE)
(72) Erfinder: PÖLLOTH, Horst, 80933 München (DE); EDER, Andreas, 81475 München (DE); LINDE, Matthias, 85540 München (DE); MAZAR, Boris, 80807 München (DE); LIMBECK, Sigrid, 53804 Much (DE); BRÜCK, Rolf, 51429 Bergisch Gladbach (DE)
(74) Vertreter: Rössler, Matthias
(86) Internationale Anmeldenummer: PCT/EP2012/051083
(87) Internationale Veröffentlichungsnummer: WO 2012/101145

(56) Entgegenhaltungen:
- CN-Y- 2 381 023
- US-A1- 2009 243 078
- US-B1- 6 359 841

## Beschreibung

Die vorliegende Erfindung betrifft ein thermoelektrisches Modul mit einer Wärmeleitschicht und ein Verfahren zu dessen Herstellung.

Das Abgas aus einer Verbrennungskraftmaschine eines Kraftfahrzeugs besitzt thermische Energie, welche mittels eines thermoelektrischen Generators in elektrische Energie umgewandelt werden kann, um beispielsweise eine Batterie oder einen anderen Energiespeicher zu füllen und/oder elektrischen Verbrauchern die benötigte Energie direkt zuzuführen. Damit wird das Kraftfahrzeug mit einem verbesserten energetischen Wirkungsgrad betrieben und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p-dotiert und n-dotiert), die auf ihrer Oberseite und Unterseite (hin zur Heißseite bzw. zur Kaltseite) wechselseitig mit elektrisch leitenden Brückenelementen versehen sind. Diese zwei Halbleiterelemente bilden die kleinste thermoelektrische Einheit bzw. ein thermoelektrisches Element. Thermoelektrische Materialien sind von einer Art, dass diese effektiv thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n-dotiert und p-dotiert) in direkten elektrischen Kontakt gebracht. Mittels einer angeschlossenen elektrischen Last kann der Stromkreis geschlossen und somit eine elektrische Leistung abgegriffen werden.

Um eine dauerhafte Einsatzfähigkeit der Halbleiterelemente zu gewährleisten, wird zwischen elektrisch leitenden Brückenelementen und dem thermoelektrischen Material regelmäßig eine Diffusionsbarriere angeordnet, die ein Diffundieren von in den elektrischen Brücken oder dem Verbindungsmaterial (z. B. Lot) enthaltenem Material in das thermoelektrische Material und damit einen Effektivitätsverlust bzw. ein funktionelles Versagen des Halbleitermaterials bzw. des thermoelektrischen Elements verhindert. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brückenelemente, Isolierung und ggf. weiteren Gehäuseelementen zu einem thermoelektrischen Modul, das von einem heißen bzw. kalten Medium überströmt wird. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Material erzeugt werden kann.

Für die Anordnung solcher Halbleiterelemente in einem thermoelektrischen Modul sind regelmäßig Gehäusewände (plattenförmiges thermoelektrisches Modul) und/oder Stützrohre zur äußeren Begrenzung eines rohrförmigen thermoelektrischen Moduls vorgesehen, an denen die Halbleiterelemente befestigt, bzw. zwischen denen sie angeordnet sind. Dies führt insbesondere dazu, dass bei der Fertigung hohe Toleranzanforderungen gegeben sind, um einerseits eine passgenaue Anordnung der Halbleiterelemente mit Bezug auf die elektrischen Verbindungen sowie andererseits auf die Position der Gehäuse zu realisieren. Problematisch ist darüber hinaus, dass infolge der unterschiedlichen thermischen Belastungen der Gehäusewände bzw. Stützrohre auch unterschiedliche Ausdehnungsverhalten dieser Komponenten kompensiert werden müssen, ohne dass besonders hohe Spannungen in das thermoelektrische Material und die Verbindungen zwischen den einzelnen Bestandteilen eingeleitet werden.

Aus der US-A1-2009/243078 ist ein plattenförmiges thermoelektrisches Modul bekannt, das bei dem Einsatz von Halbleiterchips zur Umsetzung von Wärme in elektrische Energie eingesetzt werden kann. Dabei wird ein wärmeleitender Abstandshalter eingesetzt, der das thermoelektrische Modul mit einer Aufnahmeplatte verbindet.

Die CN-Y-2381023 ist auf ein plattenförmiges thermoelektrisches Modul gerichtet, wobei zwischen den thermoelektrischen Materialien und den isolierenden äußeren Wandungen elastische Schichten angeordnet sind. Diese Schichten sind wärmeleitend ausgeführt.

Aus der US-B1-6,359,841 ist eine Anordnung eines thermoelektrischen Moduls in einer Armbanduhr bekannt. Dabei wird ein plattenförmiges thermoelektrisches Modul zwischen zwei wärmeleitenden Platten angeordnet. Zumindest die eine wärmeleitende Platte ist über eine elastische Schicht mit dem Gehäuse verbunden.

Hiervon ausgehend ist es Aufgabe der vorliegenden Erfindung, die mit Bezug auf den Stand der Technik geschilderten Probleme zumindest teilweise zu lösen. Insbesondere soll ein thermoelektrisches Modul angegeben werden, das unterschiedliche thermische Ausdehnungen kompensieren kann bzw. durch diese nicht zerstört oder in seiner Funktion eingeschränkt wird. Insbesondere soll weiterhin ein Verfahren zur Herstellung eines thermoelektrischen Moduls angegeben werden, durch das einerseits im Betrieb des thermoelektrischen Moduls auftretende unterschiedliche Wärmeausdehnungen berücksichtigt werden, und das andererseits besonders kostengünstig durchzuführen ist, indem größere Bauteiltoleranzen kompensiert werden können.

Diese Aufgaben werden gelöst mit einem thermoelektrischen Modul gemäß den Merkmalen des Patentanspruches 1. Vorteilhafte Ausgestaltungen der Erfindung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Das erfindungsgemäße thermoelektrische Modul weist zumindest eine Kaltseite, eine Heißseite sowie dazwischen angeordnete thermoelektrische Elemente auf. Zwischen den thermoelektrischen Elementen und der Kaltseite und/oder zwischen den thermoelektrischen Elementen und der Heißseite ist wenigstens eine Wärmeleitschicht angeordnet. Es ist dabei vorgesehen, dass die Wärmeleitschicht kompressibel ausgeführt ist. Insbesondere ist das thermoelektrische Modul rohrförmig aufgebaut, wobei kreisringförmige oder kreisringsegmentförmige Halbleiterelemente zwischen einem Innenrohr und einem Außenrohr in axialer Richtung hintereinander angeordnet sind. Bevorzugt wird das innere Rohr von Abgas durchströmt und das äußere Rohr von einem Kühlmedium überströmt, so dass innen die Heißseite und außen die Kaltseite des thermoelektrischen Moduls angeordnet ist. Alternativ ist das rohrförmige thermoelektrische Modul auch in umgekehrter Art ausführbar, so dass das Abgas das äußere Rohr überströmt. Insbesondere ist das thermoelektrische Modul auch plattenförmig ausführbar, so dass thermoelektrische Elemente in einer Ebene nebeneinander angeordnet sind. Dabei ist jeweils eine Seite als Kaltseite und eine gegenüberliegend angeordnete Seite als Heißseite ausgeführt. Die folgenden Ausführungen sind entsprechend auf ein plattenförmiges thermoelektrisches Modul übertragbar, wobei die vorliegende Erfindung besonders vorteilhaft für rohrförmige thermoelektrische Module ist.

Insbesondere ist das thermoelektrische Modul ausgehend von einer Kaltseite, die von einem Kühlmedium überströmt wird, in Richtung der Heißseite wie folgt aufgebaut: Kaltseite, elektrische Isolation, elektrisch leitende Brückenelemente, ggf. Diffusionssperre, thermoelektrisches Material, ggf. Diffusionssperre, elektrisch leitende Brückenelemente, elektrische Isolation, Heißseite.

Es ist nun vorgesehen, dass zumindest insbesondere zwischen einer die Kaltseite oder Heißseite bildenden äußeren Wandung und den elektrisch leitenden Brückenelementen eine Wärmeleitschicht angeordnet ist, die für einen guten Wärmeübergang zwischen thermoelektrischen Elementen und der Kaltseite bzw. Heißseite sorgt und andererseits insbesondere eine elektrische Isolierung bewirkt zwischen der Kaltseite und elektrisch leitenden Brückenelementen oder zwischen der Heißseite und elektrisch leitenden Brückenelementen.

Diese Wärmeleitschicht kann insbesondere entweder zusammen mit einer elektrischen Isolation zur Anwendung gelangen oder die elektrische Isolationsschicht ersetzen. Die Wärmeleitschicht ist kompressibel ausgeführt, das heißt, sie ist durch Aufbringen eines äußeren Druckes (insbesondere zumindest teilweise elastisch) zusammenpressbar bzw. im Volumen reduzierbar. Durch diese Kompressibilität wird es ermöglicht, dass durch thermische Belastung hervorgerufene Spannungen innerhalb des thermoelektrischen Moduls von der Wärmeleitschicht aufgenommen werden. Dies ist möglich, da sich unterschiedlich ausdehnende Bauteile insbesondere in die Wärmeleitschicht hinein erstrecken, bzw. an diese angrenzen, und deren Ausdehnung durch die kompressible Wärmeleitschicht kompensiert werden kann. Insbesondere ist die Wärmeleitschicht so ausgeführt, dass die Reduktion des Volumens der Wärmeleitschicht vollständig reversibel ist. Dadurch ist es möglich, dass die Wärmeleitschicht den Bereich zwischen Heißseite und thermoelektrischen Elementen oder zwischen Kaltseite und thermoelektrischen Elementen auch bei wechselnder thermischer Beanspruchung dauerhaft vollständig ausfüllt.

Die Wärmeleitschicht weist insbesondere eine Wärmeleitfähigkeit (bei Raumtemperatur, also 20 °C) von mindestens 0,9 W/Km [Watt/(Kelvin*Meter)], insbesondere von mindestens 9 W/Km und bevorzugt von mindestens 50 W/Km auf. Bevorzugt weist die Wärmeleitschicht einen spezifischen elektrischen Widerstand von mindestens 1 x 10⁶ Ωm [Ohm*Meter], insbesondere mindestens 1 x 10⁸ Ωm und bevorzugt von mindestens 1 x 10⁹ Ωm auf.

Weiterhin werden durch die Wärmeleitschicht insbesondere unterschiedliche Bauteiltoleranzen kompensiert, wobei dies bei der konstruktiven Auslegung des thermoelektrischen Moduls bereits berücksichtigt werden kann. Damit sind an die miteinander verbauten Komponenten des thermoelektrischen Moduls geringere Toleranzanforderungen zu stellen, so dass das thermoelektrische Modul insgesamt kostengünstiger herzustellen ist.

Erfindungsgemäß ist die wenigstens eine Wärmeleitschicht flächig ausgeführt und weist eine Dicke auf. Die Wärmeleitschicht ist in einem Temperaturbereich von 80 bis 550 °C, insbesondere in einem Temperaturbereich von 80 bis 350 °C durch einen Flächendruck von bis zu 60 N/cm² um mindestens 5 Vol.-% komprimierbar und damit in ihrer Dicke reduzierbar. Insbesondere ist die Wärmeleitschicht in dem oben genannten Temperaturbereich bei einem Flächendruck von bis zu 60 N/cm² um mindestens 10 % komprimierbar, wobei bevorzugt maximal 25 % erreicht werden können. Insbesondere liegt die Dicke der (nicht komprimierten) Wärmeleitschicht in einem Bereich von 50 bis 2000 µm [Mikrometer], bevorzugt in einem Bereich von 50 bis 150 um, so dass eine dünne und gleichzeitig kompressible Wärmeleitschicht bereitgestellt werden kann.

Gemäß einer weiteren vorteilhaften Ausgestaltung ist die wenigstens eine Wärmeleitschicht eine Folie. Die Folie ist insbesondere flexibel und biegsam und kann entsprechend zwischen der Heißseite und thermoelektrischen Elementen oder zwischen der Kaltseite und thermoelektrischen Elementen angeordnet werden.

Gemäß einer weiteren vorteilhaften Ausgestaltung des thermoelektrischen Moduls ist die wenigstens eine Wärmeleitschicht mittels eines Klebers zumindest an eine äußere Wandung des thermoelektrischen Moduls oder/und hin zu den thermoelektrischen Elementen angebunden. Dabei ist der Kleber insbesondere dazu geeignet, das thermoelektrische Modul an der Kaltseite und/oder an der Heißseite gegenüber einem Abgas bzw. einem Kühlmedium abzudichten. Somit kann der Zwischenraum des thermoelektrischen Moduls, in dem unter anderem die thermoelektrischen Elemente angeordnet sind, gasdicht bzw. fluiddicht gegenüber einem Abgas und/oder einem Kühlmedium ausgeführt werden. Insbesondere weist der Kleber dabei ebenfalls eine sehr gute thermische Leitfähigkeit auf (bei Raumtemperatur, also 20 °C) von mindestens 0,9 W/Km [Watt/(Kelvin*Meter)], insbesondere von mindestens 9 W/Km und bevorzugt von mindestens 50 W/Km auf. Bevorzugt weist der Kleber einen spezifischen elektrischen Widerstand von mindestens 1 x 10⁶ Ωm [Ohm*Meter], insbesondere mindestens 1 x 10⁸ Ωm und bevorzugt von mindestens 1 x 10⁹ Ωm auf.

Gemäß einer weiteren vorteilhaften Ausgestaltung umfasst die wenigstens eine Wärmeleitschicht eine Wärmeleitpaste. Die Wärmeleitpaste ist pastös und weist insbesondere bei Raumtemperatur eine Viskosität von mindestens 1 N/m² [Newton pro Quadratmeter] auf, bevorzugt zwischen 5 N/m² und 50 N/m² auf. Der Einsatz einer Wärmeleitpaste erfordert insbesondere eine zusätzliche elektrische Isolationsschicht. Während die Wärmeleitschicht, wenn sie als Folie ausgeführt ist, in einer konkreten Größe bzw. in einer konkreten Dicke zu verwenden ist, wird die Wärmeleitschicht, wenn sie als Wärmeleitpaste zur Anwendung kommt, lediglich durch eine bestimmte Menge (Volumen bei Raumtemperatur und Umgebungsdruck, also ca. 20 °C und 1 bar) definiert. Insbesondere enthält die Wärmeleitpaste die folgenden Materialien: Graphit, Silikon. Insbesondere ist die Wärmeleitpaste silikonfrei ausgeführt. Die Wärmeleitpaste kann insbesondere metallische Bestandteile enthalten, z. B. Aluminium. Die metallischen Bestandteile liegen insbesondere pulverförmig in der Wärmeleitpaste vor und bewirken eine hohe thermische Leitfähigkeit und hohe thermische Beständigkeit der Wärmeleitpaste.

Gemäß einer weiteren vorteilhaften Ausgestaltung umfasst die wenigstens eine Wärmeleitschicht ein Silikonelastomer/Silikongummi. Dieses kann insbesondere als Folie oder als Wärmeleitpaste ausgeführt sein.

Bevorzugt wird die Wärmeleitpaste bei plattenförmigen thermoelektrischen Modulen eingesetzt. Die Wärmeleitfolie kann zudem bei rohrförmigen thermoelektrischen Modulen eingesetzt werden.

Gemäß einer weiteren besonders vorteilhaften Ausgestaltung ist die wenigstens eine Wärmeleitschicht mit Fasern verstärkt. Die Fasern sind dabei insbesondere untereinander vernetzt, so dass die Wärmeleitschicht eine höhere Festigkeit bzw. Steifigkeit bzw. Reißfestigkeit aufweist. Durch den Einsatz von Fasern kann auch die Kompressibilität bzw. Verformbarkeit der Wärmeleitschicht angepasst werden. Als Fasern kommen insbesondere Glasfasern zum Einsatz. Diese werden insbesondere in einem Silikongummi eingebettet.

Insbesondere wird ein Verfahren zur Herstellung eines thermoelektrischen Moduls, insbesondere eines erfindungsgemäßen thermoelektrischen Moduls vorgeschlagen, das zumindest die folgenden Schritte aufweist:
a) Bereitstellen eines inneren Rohres,
b) Anordnen von thermoelektrischen Elementen an dem inneren Rohr,
c) Anordnen von elektrisch leitenden Brückenelementen zur elektrisch leitenden Verbindung der thermoelektrischen Elemente untereinander, so dass eine erste rohrförmige Anordnung mit einer Außenumfangsfläche hergestellt ist,
d) Anordnen einer komprimierbaren Wärmeleitschicht auf der Außenumfangsfläche,
e) Anordnen eines Außenrohres,
f) Kalibrieren des Außenrohres, so dass die Wärmeleitschicht komprimiert wird.

Insbesondere erfolgt durch das Kalibrieren des Außenrohres eine Verringerung des Durchmessers des Außenrohres, so dass (nur) die innerhalb des Außenrohres angeordnete Wärmeleitschicht zwischen den thermoelektrischen Elementen und dem Außenrohr komprimiert wird. Insbesondere wird ein Druck zwischen 10 und 100 N/cm² aufgebracht, wobei insbesondere zusätzlich das Außenrohr und ggf. auch das thermoelektrische Modul bis auf eine Temperatur von höchstens 400 °C erwärmt werden.

Insbesondere wird durch das Kalibrieren das Außenrohr derart in seinem Durchmesser verringert, dass die darin angeordnete Wärmeleitschicht um mindestens 5 Vol.-% komprimiert wird und damit in ihrer Dicke insbesondere um 5 % reduziert wird. Insbesondere wird eine Reduktion der Dicke bzw. eine Komprimierung des Volumens von mindestens 10 % und bevorzugt höchstens 25 % erreicht. Durch die Komprimierung der Wärmeleitschicht wird es ermöglicht, dass insbesondere die thermoelektrischen Elemente aber auch andere Bauelemente insbesondere in radialer Richtung des thermoelektrischen Moduls mit größeren Toleranzen ausgeführt werden können, da durch die Anordnung der Wärmeleitschicht Spannungsspitzen an den einzelnen Bauteilen, die durch die Kalibrierung sonst hervorgerufen werden, vermieden werden.

Die Wärmeleitschicht wird insbesondere an unterschiedlichen Stellen unterschiedlich stark komprimiert, so dass die oben beschriebenen Werte hinsichtlich der Dicke und des komprimierbaren Volumens nur als Durchschnittswerte über die gesamte Erstreckung der Wärmeleitschicht angesehen werden können. Insbesondere ist es möglich, dass einzelne punktuelle Bereiche stärker oder weniger stark komprimiert werden, so dass das Material der Wärmeleitschicht an verschiedenen Positionen unterschiedlich stark verdrängt wird. Dennoch stellt sich bevorzugt über die gesamte Erstreckung der Wärmeleitschicht eine gleichmäßige Dichte des Materials der Wärmeleitschicht ein, so dass insbesondere über die gesamte Erstreckung der Wärmeleitschicht nahezu konstante Eigenschaften (hinsichtlich Wärmeleitung und elektrischer Isolation der Wärmeleitschicht oder ähnliches) vorliegen.

Insbesondere erfolgen zwischen Schritt a) und Schritt b) die folgenden Zwischenschritte:
i. Aufbringen einer Isolierschicht auf das innere Rohr,
ii. Anordnen von elektrisch leitenden Brückenelementen zur elektrisch leitenden Verbindung der thermoelektrischen Elemente untereinander.

Gemäß einer weiteren vorteilhaften Weiterbildung des Verfahrens wird zwischen innerem Rohr und den thermoelektrischen Elementen zusätzlich eine Wärmeleitschicht angeordnet. Insbesondere wird hier vorgeschlagen, dass die Kalibrierung auch über das Außenrohr erfolgt, wobei das innere Rohr z. B. durch einen Dorn stabilisiert wird, so dass eine Reduzierung des Durchmessers des inneren Rohres hier nicht erfolgt, sondern nur eine Komprimierung des Bauraumes zwischen innerem Rohr und äußerem Rohr vorgenommen wird. Alternativ kann eine Kalibrierung (z. B. durch ein flüssiges Druckmedium) allein oder zusätzlich am Innenrohr erfolgen.

Gemäß einer weiteren vorteilhaften Ausgestaltung des Verfahrens wird durch das Kalibrieren ausschließlich das Außenrohr plastisch verformt, so dass bei Kalibrierung des Außenrohres insbesondere keine Veränderung des Durchmessers des Innenrohres erfolgt.

Generell ist zu beachten, dass bei der Kalibrierung die thermoelektrischen Elemente nicht beschädigt werden. Gerade bei ringsegmentförmigen Halbleiterelementen kann eine Lageverschiebung der Halbleiterelemente infolge der Kalibrierung jedoch toleriert werden. Ebenfalls ist es bevorzugt möglich, dass zumindest die Halbleiterelemente infolge des Kalibrierungsdruckes gesintert werden, so dass damit auch eine zwischen Innenrohr und Halbleiterelementen angeordnete Wärmeleitschicht zumindest teilweise komprimiert werden kann. Weiterhin können z. B. Sollbruchstellen in den Halbleiterelementen vorgesehen sein, so dass diese einerseits als bevorzugt ringförmige Elemente verbaut werden, andererseits aber eine Lageverschiebung aufgrund der Kalibrierung mitmachen können, ohne dass sonstige ungewollte Spannungsrisse entstehen.

Bei einem plattenförmigen thermoelektrischen Modul stellen sich die Probleme hinsichtlich Anordnung einer weiteren Wärmeleitschicht an dem Innenrohr nicht, da hier die konstruktive Gestaltung und auch das Verfahren "symmetrisch" ausgeführt werden kann. Die obigen Ausführungen sind aber entsprechend auf plattenförmige thermoelektrische Module übertragbar.

Insbesondere wird durch das vorgeschlagene thermoelektrische Modul, bzw. durch das Verfahren, der Einsatz eines Lötwerkstoffes zur Anbindung der Heißseite bzw. der Kaltseite an die thermoelektrischen Elemente vermieden. Insbesondere wird also eine lötfreie Anordnung bzw. ein lotfreies Verfahren zur Herstellung eines thermoelektrischen Moduls vorgeschlagen, so dass eine Montage der Anordnung in ein Außenrohr möglich ist, ohne dass eine stoffschlüssige Verbindung zwischen thermoelektrischen Elementen und dem Außenrohr und/oder dem Innenrohr mittelbar oder unmittelbar erzeugt wird. "Mittelbar" bezeichnet z. B. die Anordnung einer Lötverbindung zwischen einer elektrischen Isolationsschicht und dem Außenrohr bzw. dem Innenrohr oder zwischen den elektrisch leitenden Brückenelementen und der elektrischen Isolationsschicht, so dass also thermoelektrische Elemente und die Kaltseite oder Heißseite nicht direkt ("unmittelbar") durch die Lötverbindung miteinander verbunden sind. "Stoffschlüssig" bezeichnet eine Verbindung von Komponenten miteinander, die durch atomare oder molekulare Kräfte zusammengehalten werden. Dies sind insbesondere nicht lösbare Verbindungen, die sich nur durch Zerstörung der Verbindungsmittel trennen lassen.

Insbesondere kann das thermoelektrische Modul in einem thermoelektrischen Generator eingesetzt werden, der bevorzugt in der Abgasanlage einer Verbrennungskraftmaschine in einem Kraftfahrzeug eingesetzt wird.

Durch die vorliegende Erfindung ist es möglich, ein thermoelektrisches Modul bereitzustellen bzw. herzustellen, bei dem nur vertret- und machbare Anforderungen an die Toleranzen der einzelnen miteinander kombinierten Bauteile gestellt werden müssen. Die Bauteiltoleranzen werden bereits bei der Herstellung des thermoelektrischen Moduls durch die kompressible Wärmeleitschicht kompensiert. Zudem wird auch die unterschiedliche Ausdehnung einzelner Bauteile infolge thermischer Belastung während des Betriebes durch die Wärmeleitschicht ausgeglichen. Durch den Verzicht auf eine stoffschlüssige und zumindest in radialer Richtung steife (nicht flexible) Verbindung (Lötverbindung) zwischen thermoelektrischen Elementen und der Heißseite bzw. der Kaltseite kann weiterhin die Empfindlichkeit gegenüber (unterschiedlichen) Wärmeausdehnungen verringert werden. Der Einsatz einer kompressiblen Wärmeleitschicht ermöglicht damit erstmals den Einsatz eines gegenüber thermischen Wechselbeanspruchungen dauerfesten thermoelektrischen Moduls, ohne dass aufwendige Maßnahmen zum Ausgleich von thermischen Spannungen konstruktiv vorgesehen sein müssen.

Es wird ausdrücklich darauf hingewiesen, dass Merkmale, die im Zusammenhang mit dem thermoelektrischen Modul oder mit dem Kraftfahrzeug beschrieben wurden, auch für das Verfahren oder für plattenförmige thermoelektrische Module zur Anwendung gelangen können und umgekehrt.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein thermoelektrisches Modul mit einer Wärmeleitschicht,
- Fig. 2:: Schritt a) eines Herstellungsverfahrens,
- Fig. 3:: Schritt b) eines Herstellungsverfahrens,
- Fig. 4:: Schritt c) eines Herstellungsverfahrens,
- Fig. 5:: Schritt d) eines Herstellungsverfahrens,
- Fig. 6:: Schritt e) eines Herstellungsverfahrens, und
- Fig. 7:: Schritt f) eines Herstellungsverfahrens, sowie
- Fig. 8:: ein Kraftfahrzeug mit einer Abgasbehandlungsvorrichtung.

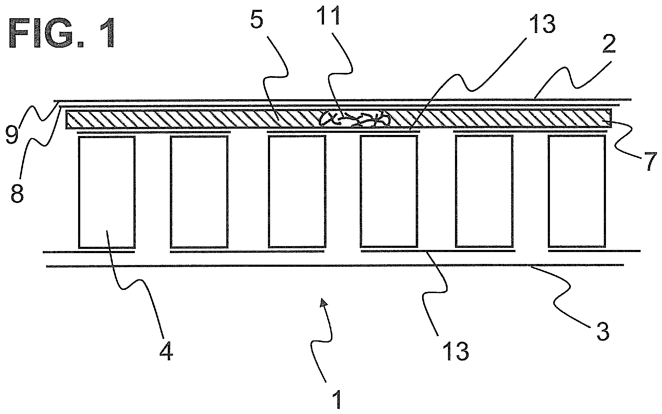

Fig. 1 zeigt ein plattenförmiges thermoelektrisches Modul 1, wobei thermoelektrische Elemente 4 zwischen einer Kaltseite 2 und einer Heißseite 3 nebeneinander in einer Ebene angeordnet sind. Die thermoelektrischen Elemente 4, die durch jeweils mindestens ein n-dotiertes und ein p-dotiertes Halbleiterelement gebildet werden, sind durch elektrisch leitende Brückenelemente 13 wechselweise miteinander verbunden. Zwischen den elektrisch leitenden Brückenelementen 13 und der Kaltseite 2 ist eine kompressible Wärmeleitschicht 5, hier als Folie 7 dargestellt, vorgesehen.

Zwischen der Wärmeleitschicht 5 und der Kaltseite 2 ist weiterhin ein Kleber 8 angeordnet, so dass Wärmeleitschicht 5 und Kaltseite 2 miteinander adhäsiv verbunden sind. Die Wärmeleitschicht 5 ist also mittels eines Klebers 8 zumindest an eine äußere Wandung 9 des thermoelektrischen Moduls 1 angebunden. Ein Ausschnitt in der Wärmeleitschicht 5 zeigt, dass diese Fasern 11 aufweist.

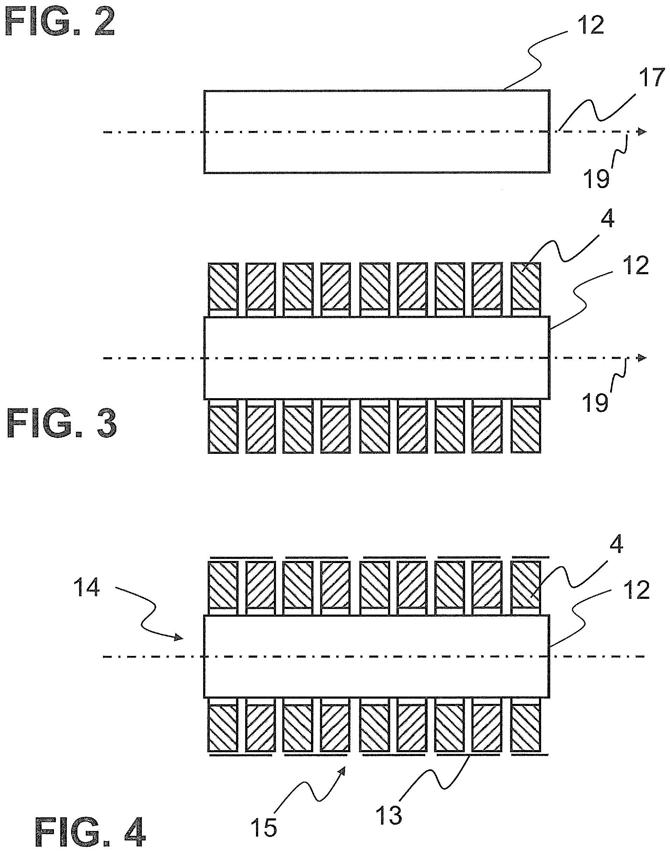

Fig. 2 zeigt Schritt a) des Verfahrens zur Herstellung eines thermoelektrischen Moduls 1, wobei ein Innenrohr 12, das sich entlang einer Mittelachse 17 in axialer Richtung 19 erstreckt, bereitgestellt wird.

In den folgenden Figuren werden nur einzelne Komponenten eines thermoelektrischen Moduls 1 gezeigt, wobei z. B. die Anordnung von elektrisch leitenden Brückenelementen 13 auch auf der Innenseite der thermoelektrischen Elemente 4 für den Fachmann selbstverständlich ist und entsprechend weggelassen wurde.

Fig. 3 zeigt Schritt b) des Verfahrens zur Herstellung eines thermoelektrischen Moduls, wobei auf dem Innenrohr 12 ringförmige thermoelektrische Elemente 4 hintereinander in einer axialen Richtung 19 angeordnet werden. Die thermoelektrischen Elemente 4 werden durch jeweils ein n-dotiertes und ein p-dotiertes Halbleiterelement gebildet, die nebeneinander angeordnet sind (unterschiedlich schraffiert).

Fig. 4 zeigt Schritt c) des Herstellungsverfahrens eines thermoelektrischen Moduls, wobei die wechselweise angeordneten n-dotierten und p-dotierten Halbleiterelemente elektrisch leitend miteinander zu thermoelektrischen Elementen 4 verbunden sind, so dass ein Strompfad durch das thermoelektrische Modul erzeugbar ist. Durch die elektrisch leitenden Brückenelemente 13 wird eine Außenumfangsfläche 15 gebildet. Durch den Schritt c) des Verfahrens wird eine Anordnung 14 gebildet.

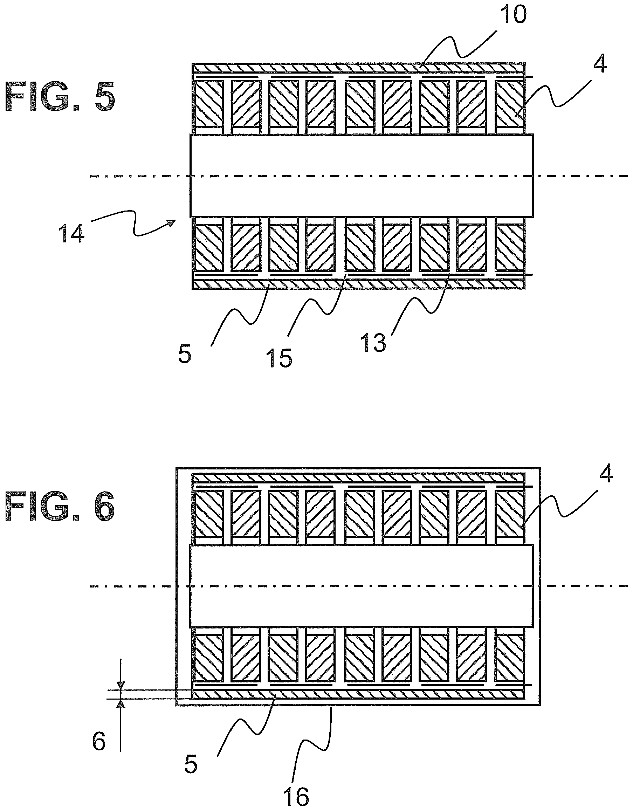

Fig. 5 zeigt Schritt d) des Verfahrens zur Herstellung eines thermoelektrischen Moduls, wobei auf der zumindest durch die elektrisch leitenden Brückenelemente 13 gebildeten Außenumfangsfläche 15 der Anordnung 14 eine kompressible Wärmeleitschicht 5 angeordnet wird. Die Wärmeleitschicht 5 ist hier als Wärmeleitpaste 10 aufgetragen.

Fig. 6 zeigt Schritt e) des Verfahrens zur Herstellung eines thermoelektrischen Moduls, wobei ein Außenrohr 16 auf die Wärmeleitschicht 5 aufgeschoben wird, so dass die Wärmeleitschicht 5 zwischen Außenrohr 16 und thermoelektrischen Elementen 4 angeordnet ist. Die Wärmeleitschicht 5 weist eine (noch) nicht komprimierte Dicke 6 auf.

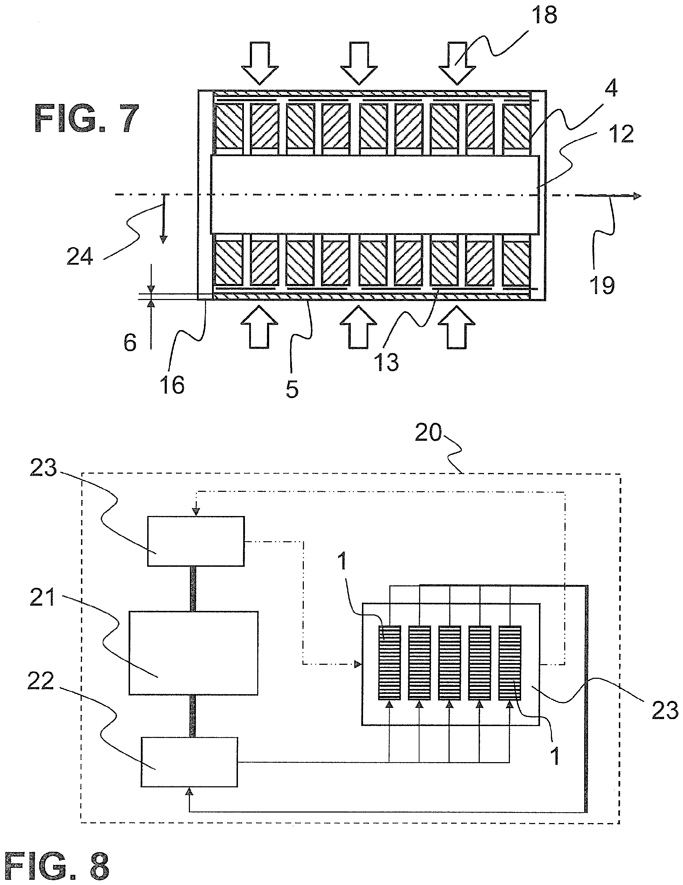

Fig. 7 zeigt den Verfahrensschritt f) zur Herstellung eines thermoelektrischen Moduls, wobei durch einen Druck 18 das Außenrohr 16 so kalibriert wird, dass die Wärmeleitschicht 5 komprimiert wird und entsprechend die Dicke 6 reduziert wird. Damit erfolgt eine thermisch leitende Anbindung von Kaltseite 2 und Heißseite 3 durch die zumindest in radialer Richtung 24 spaltfreie Verbindung von Innenrohr 12, thermoelektrischen Elementen 4, Wärmeleitschicht 5 und Außenrohr 16. Der hier gezeigte radiale Spalt zwischen den thermoelektrischen Elementen 4 und dem Innenrohr 12 ist bei dem thermoelektrischen Modul z. B. durch eine elektrische Isolation und elektrisch leitende Brückenelemente ausgefüllt. Der ebenfalls gezeigte Spalt in axialer Richtung 19 zwischen den thermoelektrischen Elementen 4 ist insbesondere durch einen elektrischen und thermischen Isolator ausgefüllt.

Fig. 8 zeigt ein Kraftfahrzeug 20 mit einer Verbrennungskraftmaschine 21 und einer Abgasbehandlungseinrichtung 22. Die Abgasbehandlungseinrichtung 22 wird von einem Abgas durchströmt, das auch einer Mehrzahl von thermoelektrischen Modulen 1 zugeführt wird. Zur Ausbildung eines Temperaturpotentials über den thermoelektrischen Modulen 1 werden diese gleichzeitig mit einem Kühlmedium einer Kühlung 23 beaufschlagt, wobei die Kühlung 23 auch zur Kühlung der Verbrennungskraftmaschine 21 vorgesehen ist.

### Bezugszeichenliste

- 1: thermoelektrisches Modul
- 2: Kaltseite
- 3: Heißseite
- 4: thermoelektrisches Element
- 5: Wärmeleitschicht
- 6: Dicke
- 7: Folie
- 8: Kleber
- 9: Wandung
- 10: Wärmeleitpaste
- 11: Faser
- 12: Innenrohr
- 13: Brückenelement
- 14: Anordnung
- 15: Außenumfangsfläche
- 16: Außenrohr
- 17: Mittelachse
- 18: Druck
- 19: axiale Richtung
- 20: Kraftfahrzeug
- 21: Verbrennungskraftmaschine
- 22: Abgasbehandlungseinrichtung
- 23: Kühlung
- 24: radiale Richtung

## Patentansprüche

1. Thermoelektrisches Modul (1) zumindest aufweisend eine Kaltseite (2), eine Heißseite (3) sowie dazwischen angeordnete thermoelektrische Elemente (4), wobei zwischen den thermoelektrischen Elementen (4) und zumindest einer die Kaltseite (2) oder die Heißseite (3) bildenden äußeren Wandung (9) wenigstens eine Wärmeleitschicht (5) angeordnet ist, wobei die Wärmeleitschicht (5) kompressibel ist, **dadurch gekennzeichnet, dass** die wenigstens eine Wärmeleitschicht (5) flächig ausgeführt ist, eine Dicke (6) aufweist und ineinem Temperaturbereich von 80 bis 550 °C durch einen Flächendruck von bis zu 60 Newton/cm² um mindestens 5 Vol.-%komprimierbar und damit in ihrer Dicke (6) reduzierbar ist; so dass durch thermische Belastung hervorgerufene Spannungeninnerhalb des thermoelektrischen Moduls von der Wärmeleitschicht aufgenommen werden.

2. Thermoelektrisches Modul (1) gemäß einem der vorhergehenden Patentansprüche, wobei die wenigstens eine Wärmeleitschicht (5) eine Folie (7) ist.

3. Thermoelektrisches Modul (1) gemäß einem der vorhergehenden Patentansprüche, wobei die wenigstens eine Wärmeleitschicht (5) mittels eines Klebers (8) zumindest an eine äußere Wandung (9) des thermoelektrischen Moduls (1) oder hin zu den thermoelektrischen Elementen (4) angebunden ist.

4. Thermoelektrisches Modul (1) gemäß einem der vorhergehenden Patentansprüche, wobei die wenigstens eine Wärmeleitschicht (5) eine Wärmeleitpaste (10) umfasst.

5. Thermoelektrisches Modul (1) gemäß einem der vorhergehenden Patentansprüche, wobei die wenigstens eine Wärmeleitschicht (5) ein Silikonelastomer umfasst.

6. Thermoelektrisches Modul (1) gemäß einem der vorhergehenden Patentansprüche, wobei die wenigstens eine Wärmeleitschicht (5) mit Fasern (11) verstärkt ist.

## Claims

1. Thermoelectric module (1) comprising at least a cold side (2), a hot side (3) and thermoelectric elements (4) disposed between them, wherein at least one heat conducting layer (5) is disposed between the thermoelectric elements (4) and an outer wall (9) forming at least the cold side (2) or the hot side (3), wherein the heat conducting layer (5) is compressible, **characterized in that** the at least one heat conducting layer (5) is implemented in planar form, has a thickness (6) and is compressible by at least 5 Vol.-% in a temperature range of 80 through 550 °C at a surface pressure of up to 60 Newton/cm² and is thus reducible in its thickness (6); so that stresses within the thermoelectric module caused by thermal load are absorbed by the heat conducting layer.

2. Thermoelectric module (1) as claimed in any one of the preceding claims, wherein the at least one heat conducting layer (5) is a film (7).

3. Thermoelectric module (1) as claimed in any one of the preceding claims, wherein the at least one heat conducting layer (5) is attached by means of an adhesive (8) at least to an outer wall (9) of the thermoelectric module (1) or through to the thermoelectric elements (4).

4. Thermoelectric module (1) as claimed in any one of the preceding claims, wherein the at least one heat conducting layer (5) contains a heat conducting paste (10).

5. Thermoelectric module (1) as claimed in any one of the preceding claims, wherein the at least one heat conducting layer (5) contains a silicone elastomer.

6. Thermoelectric module (1) as claimed in any one of the preceding claims, wherein the at least one heat conducting layer (5) is reinforced with fibers (11).

## Revendications

1. Module thermoélectrique (1) comportant au moins un côté froid (2), un côté chaud (3) et des éléments thermoélectriques (4) disposés entre ceux-ci, dans lequel au moins une couche thermoconductrice (5) est disposée entre les éléments thermoélectriques (4) et au moins une paroi extérieure (9) formant le côté froid (2) ou le côté chaud (3), dans lequel la couche thermoconductrice (5) est compressible,
**caractérisé en ce que** l'au moins une couche thermoconductrice (5) est réalisée de manière plane, **en ce qu'**elle présente une épaisseur (6) et **en ce qu'**elle peut être comprimée d'au moins 5% en volume dans une plage de températures de 80 à 550°C sous une pression de surface allant jusqu'à 60 Newton/cm² et par conséquent **en ce que** son épaisseur (6) peut être réduite ; de telle sorte que des contraintes provoquées à l'intérieur du module thermoélectrique par une charge thermique sont absorbées par la couche thermoconductrice.

2. Module thermoélectrique (1) selon l'une des revendications précédentes, dans lequel l'au moins une couche thermoconductrice (5) est un film (7).

3. Module thermoélectrique (1) selon l'une des revendications précédentes, dans lequel l'au moins une couche thermoconductrice (5) est liée au moyen d'un adhésif (8) au moins à une paroi extérieure (9) du module thermoélectrique (1) ou aux éléments thermoélectriques (4).

4. Module thermoélectrique (1) selon l'une des revendications précédentes, dans lequel l'au moins une couche thermoconductrice (5) comprend une pâte thermoconductrice (10).

5. Module thermoélectrique (1) selon l'une des revendications précédentes, dans lequel l'au moins une couche thermoconductrice (5) comprend un élastomère de silicone.

6. Module thermoélectrique (1) selon l'une des revendications précédentes, dans lequel l'au moins une couche thermoconductrice (5) est renforcée par des fibres (11).
